Europäisches Patentamt

European Patent Office

Office européen des brevets

(19)

(11) Veröffentlichungsnummer: **0 023 599**
**A2**

(12) # EUROPÄISCHE PATENTANMELDUNG

(21) Anmeldenummer: **80103935.5**

(51) Int. Cl.³: **B 23 K 3/04**

(22) Anmeldetag: **09.07.80**

(30) Priorität: **06.08.79 DE 2931857**

(71) Anmelder: **SIEMENS AKTIENGESELLSCHAFT Berlin und München, Postfach 22 02 61, D-8000 München 22 (DE)**

(43) Veröffentlichungstag der Anmeldung: **11.02.81 Patentblatt 81/6**

(72) Erfinder: **Wirbser, Oscar, Kreuzlingerstrasse 73, D-8034 Germering (DE)**
Erfinder: **Unger, Gregor, Carl-Diem-Strasse 2, D-8034 Germering (DE)**
Erfinder: **Meixner, Karl, Bürgermeister-Müller-Strasse 31, D-8031 Puchheim (DE)**

(84) Benannte Vertragsstaaten: **CH FR IT LI NL**

(54) **Lötbügel für Mikrolötstellen.**

(57) Für den Einbau von Mikropacks in gedruckte Schaltungen (Leiterplatten) und in Schichtschaltungen in Dickschicht- und Dünnfilmtechnik wurde ein Lötbügel entwikkelt, der mit Hilfe einer Impulslöteinrichtung widerstandserwärmt wird. Er besteht im wesentlichen aus den Elektroden, der Rahmenthermode und dem gefederten Niederhalter, der zugleich als Saugpinzette dient und eine Freinehmung für den Chip enthält.

EP 0 023 599 A2

SIEMENS AKTIENGESELLSCHAFT      Unser Zeichen
Berlin und München              VPA
                                79 P 7 1 0 9

Lötbügel für Mikrolötstellen.

Die vorliegende Erfindung betrifft einen Lötbügel mit
Widerstandsheizung für Mikrolötstellen, insbesondere
für den Einbau von Mikropacks in gedruckten Schaltungen
(Leiterplatten) und in Schichtschaltungen in Dickschicht-
und Dünnfilmtechnik, bestehend aus einer rahmenförmigen
Thermode, die an beiden Seiten von Elektroden geführt
und an die elektrische Stromversorgung angeschlossen ist.

In der DE-OS 28 18 958 ist ein Lötstempel beschrieben
und dargestellt, an welchem über eine mechanische und
galvanische Verbindung eine Lötfläche mit im wesentlichen
rechteckiger Ausbildung angeordnet ist. Dieser Lötstempel
ist für den Einbau von Mikropacks nicht anwendbar, weil
damit nicht gewährleistet ist, daß die Anschlüsse beim
Lötvorgang auf der Schaltung aufliegen.

Der Erfindung liegt die Aufgabe zugrunde, den eingangs
genannten Lötbügel mit möglichst einfachen Mitteln so zu
realisieren, daß er vollständig auch für den Einbau von

Wed 1 Plr/1.8.1979

Mikropacks in gedruckten Schaltungen (Leiterplatten) anwendbar ist. Diese Aufgabe wird dadurch gelöst, daß die Rahmenthermode einen gefederten Niederhalter umschließt, der eine Freinehmung für die Lötstelle, insbesondere für einen Chip, enthält und daß die Rahmenthermode im Lötzustand entweder auf den Anschlüssen des Substrates bzw. auf den Anschlußenden des zu lötenden Bauteiles aufliegt. Auf diese Weise wird gewährleistet, daß die Anschlüsse beim Lötprozeß alle angedrückt werden und dadurch eine sichere Lötung insbesondere auch bei Bauelementen mit vielen Anschlüssen erzielt wird. Unterstützend kommt hinzu, daß beim Abkühlen der Niederhalter bis zum Erstarren der Lotstellen gegen die Enden der Anschlüsse des Bauelementes drückt.

Nach einer Weiterbildung der Erfindung ist der Niederhalter mit einer Vakuumzuführung versehen und dient zugleich als Saugpinzette. Das Arbeiten mit dem Lötbügel kann mit Hilfe zusätzlicher Steuerglieder auch automatisiert werden. In diesem Zusammenhang hat der Niederhalter dann eine Doppelfunktion, und zwar das Andrücken der Anschlüsse und der Saugpinzette. Hierbei wird z. B. von einer Vorratsrolle über einen Antrieb jeweils ein Mikropack zu einer Beschneidevorrichtung transportiert und nach dem Abtrennen mit Hilfe der Vakuumansaugung des Niederhalters aufgenommen. Anschließend fährt dann der Lötbügel mit dem Mikropack in die Einbauposition. Dabei wird z. B. die zu bestückende Leiterplatte mit Hilfe eines x-y-Tisches positioniert, so daß das Mikropack abgesenkt und eingelötet werden kann.

Nach einer weiteren Ausgestaltung der Erfindung ist der Niederhalter und die Thermode in z-Richtung verfahrbar, so daß an der Vorderseite des zu lötenden Gegenstandes der als Saugpinzette ausgebildete Niederhalter und an der Rückseite die Elektroden mit der Thermode angeordnet sind. Auf diese Weise wird erreicht, daß mit der Impulsbeheizten Thermode die Wärmezufuhr von der Schaltungsrückseite möglich wird, wenn infolge hoher Packungsdichte kein
Freiraum auf der Schaltung für die Thermode vorgesehen
werden kann.

Im Rahmen der Erfindung wird ferner die Temperatur der
Thermode über ein Thermoelement geregelt.

Um bei empfindlichen Halbleiterbauelementen eine Beschädigung durch den Wechselspannungsabfall an der Thermode zu vermeiden, kann die Thermode mit einer Isolierschicht, z. B. $Al_2O_3$, versehen werden.

Die Erfindung wird anhand der Figuren erläutert. Es
zeigen:

Figur 1 einen Lötbügel, bei dem Thermode und Niederhalter
auf derselben Seite der Schaltung angeordnet
sind und

Figur 2 einen Lötbügel, bei dem auf der Vorderseite der
Niederhalter und auf der Schaltungsrückseite die
Thermode angeordnet ist.

Auf einer Auflage 1 befindet sich eine Leiterplatte 2,
auf der nach der Darstellung in der Figur in der Mitte
ein Chip 3 aufliegt. Mit 4 ist eine an der Schnittstelle
sichtbare Leiterbahn und mit 5 die dazugehörige Lotschicht bezeichnet. Vom Chip 3 führen Anschlußfahnen 6
zu einem Polyimidträger 7. Eine Thermode 8 umgibt einen
Niederhalter 9, in dem Bohrungen 10 vorgesehen sind. Mit
11 sind die beabsichtigten Lötverbindungen bezeichnet.

Beim Einlöten wird das vereinzelte Mikropack 3, 6 und 7
mit der Saugpinzette in Form des Niederhalters 9 aufgenommen, auf den Einbauplatz auf der Leiterplatte 2 positioniert und aufgesetzt. Anschließend wird die rahmenförmige Thermode 8 außerhalb des Mikropacks auf die Schaltung abgesenkt, so daß die Wärme für den Lötprozeß über die beloteten Leiterbahnen an die Verbindungsstellen gelangt. Nach dem Aufschmelzen des beloteten Anschlußpartners zur Lötverbindung wird das Mikropack solange niedergehalten, bis das Lot spannungsfrei erstarrt ist. Danach werden Thermode 8 und Niederhalter 9 abgehoben.

Die indirekte Wärmezufuhr über die beloteten Leiterbahnen wurde deshalb angewendet, weil die Wärmezufuhr über den Polyimidträger 7, z. B. Kapton, zu Beschädigungen desselben führen könnte.

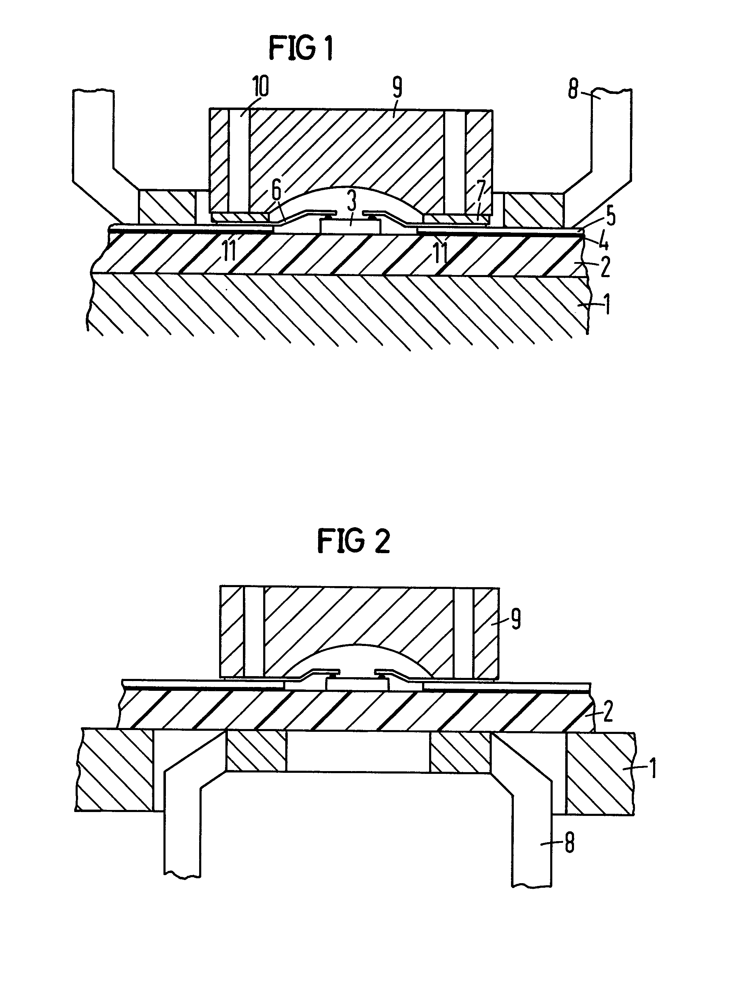

Nach der Darstellung in der Figur 2 wird der Lötbügelaufbau derart geändert, daß an der Vorderseite der als Saugpinzette ausgebildete Niederhalter 9 und an der Schaltungsrückseite die Thermode 8 angeordnet sind. Hierfür sind Niederhalter und Thermode in Z-Richtung verfahrbar ausgebildet. Bei dieser Anordnung ist die Leiterplatte 2 der Keramikträger für eine Dickschicht- oder Dünnfilmschaltung.

5 Patentansprüche
2 Figuren

0023599

Patentansprüche.

1. Lötbügel mit Widerstandsheizung für Mikrolötstellen, insbesondere für den Einbau von Mikropacks in gedruckten Schaltungen (Leiterplatten) und in Schichtschaltungen in Dickschicht- und Dünnfilmtechnik, bestehend aus einer rahmenförmigen Thermode (8), die an beiden Seiten von Elektroden geführt und an die elektrische Stromversorgung angeschlossen ist, d a d u r c h  g e k e n n - z e i c h n e t , daß die Rahmenthermode (8) einen gefederten Niederhalter (9) umschließt, der eine Freinehmung für die Lötstelle, insbesondere einen Chip (3), enthält und daß die Rahmenthermode (8) im Lötzustand entweder auf den Anschlüssen (6) des Substrats bzw. auf den Anschlußenden des zu lötenden Bauteiles aufliegt.

2. Lötbügel nach Anspruch 1, d a d u r c h  g e - k e n n z e i c h n e t , daß der Niederhalter (9) mit einer Vakuumzuführung versehen ist und zugleich als Saugpinzette dient.

3. Lötbügel nach Anspruch 1 und 2, d a d u r c h  g e k e n n z e i c h n e t , daß Niederhalter (9) und Thermode (8) in Z-Richtung verfahrbar sind, so daß an der Vorderseite des zu lötenden Gegenstandes der als Saugpinzette ausgebildete Niederhalter und an der Rückseite die Elektroden mit der Thermode angeordnet sind.

4. Lötbügel nach Anspruch 1, d a d u r c h  g e - k e n n z e i c h n e t , daß die Temperatur der Thermode (8) über ein Thermoelement geregelt wird.

5. Lötbügel nach Anspruch 1, d a d u r c h  g e - k e n n z e i c h n e t , daß die Thermode (8) mit einer Isolierschicht, z. B. $Al_2O_3$, versehen ist.

**FIG 1**

**FIG 2**